# EUROPÄISCHE PATENTSCHRIFT

(11) **EP 2 900 538 B1**
(45) Veröffentlichungstag und Bekanntmachung des Hinweises auf die Patenterteilung: **24.08.2016**
(21) Anmeldenummer: 13792337.1
(22) Anmeldetag: 14.11.2013
(51) Int. Cl.: G01R 31/44, H05B 39/04, H05B 39/09, B61L 1/20, B61L 7/10, B61L 5/18, B61L 29/30

(54) **VERFAHREN UND VORRICHTUNG ZUR FEHLEROFFENBARUNG BEI EINEM LICHTSIGNAL**
METHOD AND DEVICE FOR REVEALING A LIGHT SIGNAL ERROR
PROCÉDÉ ET DISPOSITIF DE NOTIFICATION DE DÉFAILLANCE DANS UN SIGNAL LUMINEUX

(30) Priorität: 30.11.2012 DE 102012221991
(43) Veröffentlichungstag der Anmeldung: 05.08.2015
(73) Patentinhaber: Siemens Aktiengesellschaft, 80333 München (DE)
(72) Erfinder: KÖSTER, Kay, 15370 Fredersdorf (DE); ECKL, Rolf, 12305 Berlin (DE)
(86) Internationale Anmeldenummer: PCT/EP2013/073789
(87) Internationale Veröffentlichungsnummer: WO 2014/082859

(56) Entgegenhaltungen:
- EP-A1- 2 463 174
- US-A1- 2006 001 547
- US-A1- 2006 066 447

## Beschreibung

Die Erfindung betrifft ein Verfahren zur Fehleroffenbarung bei einem Lichtsignal, insbesondere für Eisenbahnsicherungsanlagen, mit einem im Fehlerfall sich reversibel abschaltenden elektronischen Signalgeber und einem für Glühlampen konzipierten Stellteil zur Ansteuerung und Überwachung des Signalgebers sowie eine diesbezügliche Vorrichtung.

Die nachfolgende Beschreibung bezieht sich im Wesentlichen auf Lichtsignale für Eisenbahnsicherungsanlagen, ohne dass die Erfindung auf diese Anwendung beschränkt ist. Vielmehr ist eine Anwendung beispielsweise auch bei anderen Verkehrssystemen oder im industriellen Bereich denkbar.

Die Patentschrift EP 2 463 174 A1 offenbart ein Verfahren zur Fehleroffenbarung bei einem Lichtsignal bei Eisenbahnanlagen.

Stellteile, die für Glühlampen-Signale konzipiert sind, werten üblicherweise einen Signalstrom aus, um einen Fehler oder die ordnungsgemäße Funktion des Lichtsignals festzustellen. Lichtsignale auf elektronischer Basis, beispielsweise LED-Signale, benötigen einige Zeit, bis sie einen Fehler erkennen. Nach dem Einschalten des Lichtsignals werden die Schaltungsfunktionen in einem Selbsttest überprüft. Für diese Überprüfung ist ein Stromfluss notwendig, der stellteilseitig als gültiger Signalstrom bewertet wird. Nach einem fehlgeschlagenen Selbsttest, das heißt im Fehlerfall, wird der Signalgeber abgeschaltet und der Fehler wird dem Stellteil offenbart. Dazu wird der Signalstrom derart verändert, beispielsweise abgeschaltet, dass das Stellteil über diese Stromveränderung den Fehler vom Signalgeber erkennt. Durch die reversible Abschaltung mit erkannter Fehlfunktion des Signalgebers fließt nach jedem Neustart des Signals bis zu einer gegebenenfalls erneuten Fehlererkennung ein Signalstrom. Bei nichtblinkenden Signalen reicht die Stromveränderung im Fehlerfall zur Signalisierung des Fehlers aus, da die Einschaltzeit gegenüber einem Blinkimpuls sehr lang ist.

Im Blinkbetrieb fließt bei jedem Neustart, also in jedem Blinkimpuls, Strom. Der Strom fließt bis zur internen Fehlererkennung im Signalgeber. Dieser Strom kann bereits ausreichen, einen fehlerfreien Signalgeber für das Stellteil zu signalisieren. Das Abschalten des Signalgebers wegen eines eigenen Fehlers in der Ein- Phase vom Blinkbetrieb kommt somit kurz vor der Aus- Phase vom Blinkbetrieb bzw. der PulsPause und wird eventuell nicht vom Stellteil erkannt.

Der Erfindung liegt demgemäß die Aufgabe zugrunde, ein Verfahren und eine Vorrichtung der gattungsgemäßen Art anzugeben, welche eine sichere und eindeutige Fehleroffenbarung in einem Blinkmodus des Signalgebers ermöglichen.

Verfahrensgemäß wird die Aufgabe dadurch gelöst, dass bei Ansteuerung des Signalgebers in einem Blinkmodus, in dessen Blinkpausen keine Signalspannung anliegt, ein mit einer Spannungsquelle beschalteter Zeitgeber die Länge der Blinkpausen misst und den Blinkmodus erkennt.

Die Aufgabe wird auch durch eine Vorrichtung gelöst, bei der ein mit einer Spannungsquelle beschalteter Zeitgeber sowohl zur Messung der Länge von Blinkpausen in einem Blinkmodus des Signalgebers für die Erkennung des Blinkmodus als auch im Fehlerfall zur Aufrechterhaltung der Abschaltung über mindestens einen Blinkzyklus und damit zur Signalisierung der Abschaltung an das Stellteil vorgesehen ist.

Auf diese Weise wird die Blinkpause in den normalen Betrieb des Signalgebers einbezogen, ohne dass in den Blinkpausen ein Signalstrom fließt, um den Zeitgeber mit Energie zu versorgen. Dadurch wird ein Blinkbegriff zu einer auswertbaren Funktion des Signalgebers, welcher mit in den Selbsttest implementiert wird. Bei einem Fehler schaltet der elektronische Signalgeber automatisch ab und merkt sich mit Hilfe des Zeitgebers den Fehler über die Blinkpause und bleibt nach der Blinkpause weiterhin für ein bis mehrere Blinkzyklen in der Abschaltung. Nach Ablauf der Signalisierung des Fehlers beendet der Zeitgeber die Abschaltzeit, so dass ein Neustart des reversibel abschaltbaren elektronischen Signalgebers freigegeben wird. Zur Messung der Länge der Blinkpausen, das heißt für die Erkennung des Blinkmodus, wird vorzugsweise der gleiche Zeitgeber verwendet wie für die Signalisierung des Fehlers. Das Stellteil erkennt den Fehler wie bei einer defekten Glühlampe anhand der Veränderung des Signalstromes bei einem Stromimpuls eines Blinkzyklus und der nachfolgenden, mittels des Zeitgebers auf mindestens einen Blinkzyklus verlängerten Abschaltzeit. Damit kann zuverlässig eine Fehlersignalisierung über eine Abschaltfunktion realisiert werden.

Gemäß Anspruch 3 ist vorgesehen, dass die Spannungsquelle des Zeitgebers als mit der Signalspannung des Signalgebers verbundene Kondensatorschaltung oder als Batterie- beziehungsweise Akkumulatorschaltung ausgebildet ist. Damit wird die Funktion der Beibehaltung der Abschaltung über eine Blinkpause bis zum Neustart sichergestellt. Die Kondensatorschaltung sorgt dafür, dass die Spannungsquelle des Zeitgebers bei jedem Blinken, das heißt bei jedem Stromimpuls des Blinkzyklus nachgeladen wird. Die Signalisierung eines Fehlers durch Abschaltung ist durch bedarfsgerechte Nachladung der Spannungsquelle des Zeitgebers mittels der Kondensatorschaltung auch über mehrere Blinkzyklen hinweg möglich, ohne dass ein für das Stellteil gültiger Signalstrom fließt.

Bei einer besonders bevorzugten, in Anspruch 4 gekennzeichneten Ausführungsform ist vorgesehen, dass der Zeitgeber mehrkanalig aufgebaut ist. Dadurch wird die hochgradig sicherheitsrelevante Signalisierung eines Fehlers auch bei einem Defekt eines Zeitgebers oder dessen zugeordneter Spannungsquelle sichergestellt.

Gemäß Anspruch 5 ist vorgesehen, dass der Zeitgeber zwei Kanäle zur Messung der Länge der Blinkpausen aufweist, wobei die Messwerte der Kanäle verglichen werden und bei Unterschieden ein Fehler signalisiert wird. Die Werte der Zeitgeber von mindestens zwei Kanälen werden in jedem Blinkzyklus verglichen und ausgewertet. Dabei reicht die Erkennung einer Blinkpause aus, um auf die Funktionstüchtigkeit des Zeitgebers zu schließen. Kann ein Kanal die Abschaltzeit nicht messen beziehungsweise erkennen, insbesondere durch Zeitgeberdefekt, ist dieser Kanal auch nicht mehr in der Lage, einen erkannten Fehler, das heißt eine Abschaltung, über eine Blinkpause hinaus an das Stellteil zu signalisieren. Durch die mehrkanalige Erkennung des Blinkzyklus und den Vergleich der Messwerte der einzelnen Kanäle kann bei Defekt in einem Kanal ein Fehler im Blinkzyklus somit noch über den fehlerfreien Kanal erkannt werden und über die Blinkpause hinaus signalisiert werden.

Vorzugsweise ist zur Überwachung der Funktion der Vorrichtung und Einbeziehung dieser in den Selbsttest und damit in die Fehleroffenbarung des Signalgebers gemäß Anspruch 6 mindestens ein Mikrocontroller vorgesehen, der in den Blinkpausen einen Sleepmodus einnimmt und mit Beginn des ersten Sleepmodus nach dem Ansteuern des Signalgebers in Blinkmodus ein Blinkbit setzt. Der Mikrocontroller fungiert während seines Sleepmodus als Zeitgeber, wobei wenig Energie aufgenommen wird, so dass die Blinkpause überbrückt werden kann. Vorzugsweise werden mehrere Mikrocontroller als Messkanäle zur Erfassung des Blinkmodus eingesetzt. In der Ein- Phase des Blinkzyklus werden die Blinkbits der Kanäle im Selbsttest miteinander verglichen. Bei Unterschieden zwischen den Kanälen wird ein fehlerhafter Selbsttest erkannt und die Signalisierung des Fehlers durch Abschaltung ausgelöst.

Die Erfindung wird nachfolgend anhand einer figürlichen Darstellung näher erläutert.

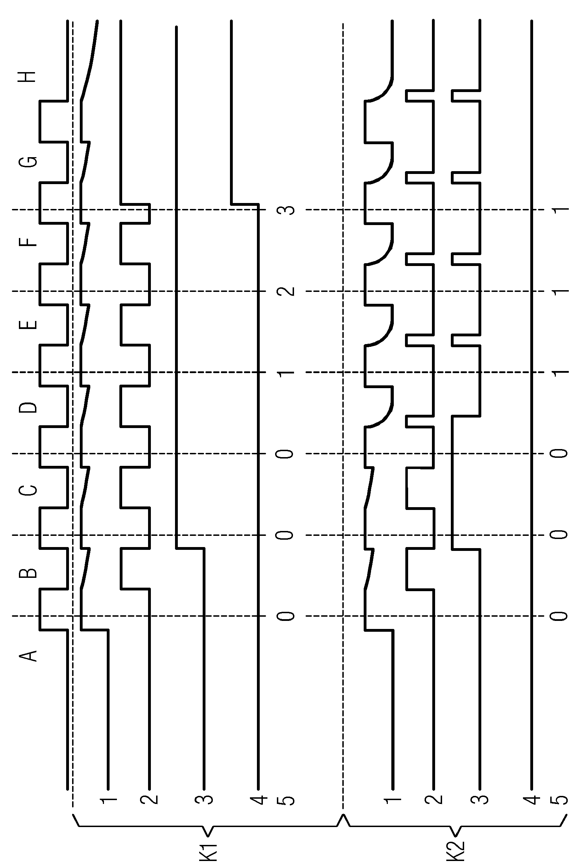

Die einzige Figur zeigt ein Zeitdiagramm zur Blinkerkennung und Abschaltung im Fehlerfall bei einem in Blinkmodus betriebenen Lichtsignal. Dargestellt sind die Zeitkurven für Blinkzyklen A bis H, Spannung einer Energiequelle 1, Zeitgeber/Sleemodus 2, Blinkbit 3, Abschalter 4 und Fehlerzähler/Energieüberwachung 5 für zwei Messkanäle K1 und K2 in zeitlicher Zuordnung. Die Zeitkurven 1 bis 5 veranschaulichen die Fehleroffenbarung bei einem reversibel abschaltbaren elektronischen Signalgeber in Blinkmodus, der an eine Glühlampenschnittstelle eins Stellteils angeschlossen ist. Zur Erfassung des Blinkmodus ist für jeden Kanal K1 und K2 ein Mikrocontroller vorgesehen.

Der Kanal K1 ist fehlerfrei und im Kanal K2 ist die Energiequelle 1 für den Sleepmodus/Zeitgeber 2 ab dem Blinkzyklus D fehlerhaft. Beim Start im Blinkzyklus A wird das Blinkbit 3 der beiden Kanäle K1 und K2 verglichen. Beide Kanäle K1 und K2 besitzen den gleichen Zustand. In den Blinkzyklen B und C schaltet sich der Mikrokontroller in den Blinkpausen in Sleepmodus 2. Da im Sleepmodus der Zeitgeber läuft, erkennt dieser die Blinkpause aufgrund der Pausenlänge und setzt das Blinkbit 3. Das Blinkbit 3 ist in den Blinkzyklen B und C bei beiden Kanälen K1 und K2 gesetzt. Durch den Fehler der Energiequelle 1 von Kanal K2 kann dieser die Blinkpausen nicht mehr messen. Das Blinkbit 3 von Kanal K2 wird deshalb nach der Blinkpause vom Blinkzyklus D zurückgesetzt. In diesem Beispiel wird ein Fehlerzähler 5 verwendet, welcher ab einer Wertigkeit 3 die Abschaltung 4 zur Fehlersignalisierung auslöst, auch wenn der Signalgeber seiner äußeren Funktion des Blinkens weiterhin nachkommt. Der Kanal K2 kann den Fehlerzähler 5 nicht mehr hochzählen, da sein Energiepuffer defekt ist. Dieser Kanal K2 startet ab dem Blinkzyklus D mehrfach neu und löscht damit seinen Fehlerzähler. Ab Blinkzyklus G erfolgt durch den intakten Kanal K1 die Abschaltung 4. Kanal K1 ist auch in der Lage, die Abschaltung 4 über wenigstens einen Blinkzyklus H aufrecht zu erhalten und signalisiert damit den Fehler mindestens während eines ganzen Blinkzyklus H an das Stellteil, welches einen falschen Signalstrom erkennt. Nach Ablauf der Fehlersignalisierung kann ein Neustart erfolgen.

## Patentansprüche

1. Verfahren zur Fehleroffenbarung bei einem Lichtsignal, insbesondere für Eisenbahnsicherungsanlagen, mit einem im Fehlerfall sich reversibel abschaltenden elektronischen Signalgeber und einem für Glühlampen konzipierten Stellteil zur Ansteuerung und Überwachung des Signalgebers, wobei bei Ansteuerung des Signalgebers in einem Blinkmodus, in dessen Blinkpausen keine Signalspannung anliegt, ein mit einer Spannungsquelle (1) beschalteter Zeitgeber (2) die Länge der Blinkpausen misst und den Blinkmodus erkennt.

2. Vorrichtung zur Durchführung des Verfahrens nach Anspruch 1,
**dadurch gekennzeichnet, dass**
ein mit einer Spannungsquelle (1)beschalteter Zeitgeber (2) sowohl zur Messung der Länge von Blinkpausen in einem Blinkmodus des Signalgebers für die Erkennung des Blinkmodus als auch im Fehlerfall zur Aufrechterhaltung der Abschaltung (4) über mindestens einen Blinkzyklus (G, H) und damit zur Signalisierung der Abschaltung (4) an das Stellteil vorgesehen ist.

3. Vorrichtung nach Anspruch 2,
**dadurch gekennzeichnet, dass**
die Spannungsquelle (1) des Zeitgebers (2) als mit der Signalspannung des Signalgebers verbundene Kondensatorschaltung oder als Batterie- beziehungsweise Akkumulatorschaltung ausgebildet ist.

4. Vorrichtung nach Anspruch 2 oder 3,
**dadurch gekennzeichnet, dass**
der Zeitgeber (2) mehrkanalig (K1, K2) aufgebaut ist.

5. Vorrichtung nach Anspruch 4,
**dadurch gekennzeichnet, dass**
der Zeitgeber (2) zwei Kanäle (K1, K2) zur Messung der Länge der Blinkpausen auf weist, wobei die Messwerte der Kanäle (K1, K2) verglichen werden und bei einem Unterschied ein Fehler signalisiert wird.

6. Vorrichtung nach einem der Ansprüche 2 bis 5,
**dadurch gekennzeichnet, dass**
der Zeitgeber (2) zur Fehleroffenbarung und zur Steuerung der Abschaltung (4) durch mindestens einen Mikrokontroller realisiert ist.

## Claims

1. Method for revealing errors in the case of a light signal, particularly for railway safety installations, having an electronic signal transmitter, which disconnects itself reversibly in the event of an error, and an actuating part, designed for incandescent lamps, for actuating and monitoring the signal transmitter,
wherein
when the signal transmitter is actuated in a flashing mode whose flash pauses have no signal voltage applied, a timer (2) with a connected voltage source (1) measures the length of the flash pauses and identifies the flashing mode.

2. Apparatus for performing the method according to Claim 1,
**characterized in that**
a timer (2) with a connected voltage source (1) is provided both for the purpose of measuring the length of flash pauses in a flashing mode of the signal transmitter for the purpose of identifying the flashing mode and in the event of an error for the purpose of maintaining the disconnection (4) over at least one flash cycle (G, H) and hence for the purpose of signaling the disconnection (4) to the actuating part.

3. Apparatus according to Claim 2,
**characterized in that**
the voltage source (1) of the timer (2) is in the form of a capacitor circuit connected to the signal voltage of the signal transmitter or in the form of a battery circuit or storage battery circuit.

4. Apparatus according to Claim 2 or 3,
**characterized in that**
the timer (2) is of multichannel (K1, K2) design.

5. Apparatus according to Claim 4,
**characterized in that** the timer (2) has two channels (K1, K2) for measuring the length of the flash pauses, wherein the measured values from the channels (K1, K2) are compared and an error is signaled if there is a difference.

6. Apparatus according to one of Claims 2 to 5,
**characterized in that**
for revelation of errors and for control of the disconnection (4) the timer (2) is realized by at least one microcontroller.

## Revendications

1. Procédé de signalisation d'erreur dans un signal lumineux, notamment pour des installations de sécurité de chemin de fer, comprenant un générateur électronique de signaux se déconnectant réversiblement en cas d'erreur et une partie de réglage conçue pour des lampes à incandescence afin d'exciter et de contrôler le générateur de signaux,
dans lequel
lorsque le générateur de signaux est excité dans un mode de clignotement, dans les intervalles entre les clignotements duquel une tension de signal n'est pas appliquée, une horloge ( 2 ) alimentée par une source ( 1 ) de tension mesure la longueur des intervalles entre les clignotements et détecte le mode de clignotement.

2. Dispositif pour effectuer le procédé suivant la revendication 1,
**caractérisé en ce que**
une horloge ( 2 ) alimentée par une source ( 1 ) de tension est prévue à la fois pour mesurer la longueur des intervalles entre les clignotements dans un mode de clignotement du générateur de signaux pour détecter le mode de clignotement et, en cas d'erreur, pour maintenir la déconnexion sur au moins un cycle ( G, H ) de clignotement et signaler ainsi la déconnexion ( 4 ) à la partie de réglage.

3. Dispositif suivant la revendication 2,
**caractérisé en ce que**
la source ( 1 ) de tension de l'horloge ( 2 ) est constituée sous la forme d'un circuit de condensateur auquel est appliquée la tension de signal du générateur de signaux ou sous la forme d'un circuit d'accumulateur ou de batterie.

4. Dispositif suivant la revendication 2 ou 3,
**caractérisé en ce que**
l'horloge ( 2 ) est constituée en ayant plusieurs canaux ( K1, K2 ).

5. Dispositif suivant la revendication 4,
**caractérisé en ce que**
l'horloge ( 2 ) a deux canaux ( K1, K2 ) pour mesurer la longueur des intervalles entre les clignotements, les valeurs de mesure des canaux ( K1, K2 ) étant comparées et, s'il y a une différence, une erreur étant signalée.

6. Dispositif suivant l'une des revendications 2 à 5,
**caractérisé en ce que**
l'horloge ( 2 ) est, pour signaler une erreur et pour commander la déconnexion ( 4 ), réalisée par au moins une micro-unité de commande.
